# EUROPEAN PATENT SPECIFICATION

(11) **EP 2 484 190 B1**
(45) Date of publication and mention of the grant of the patent: **24.02.2016**
(21) Application number: 09850161.2
(22) Date of filing: 17.12.2009
(51) Int. Cl.: H05K 7/20, H01L 29/70, H01L 23/473, H01L 23/367, F28F 3/02, F28F 3/04, H01L 21/48, B01D 8/00, B23P 15/26

(54) **COLD PLATE WITH PINS**
KÜHLPLATTE MIT STIFTEN
PLAQUE FROIDE AVEC BROCHES

(30) Priority: 03.10.2009 US 573107
(43) Date of publication of application: 08.08.2012
(73) Proprietor: Wolverine Tube, Inc., Huntsville, AL 35801 (US)
(72) Inventor: LOONG, Sy-jenq, Decatur AL 35609 (US); SMITH, Donald, Lynn, Decatur AL 35609 (US)
(74) Representative: Coyle, Philip Aidan
(86) International application number: PCT/US2009/068591
(87) International publication number: WO 2011/040938

(56) References cited:
- JP-A- 2001 352 020
- JP-A- 2005 302 898
- JP-A- 2007 003 164
- US-A1- 2005 199 372
- US-A1- 2007 163 749
- US-B1- 7 173 823

## Description

### BACKGROUND OF THE INVENTION

### Field of the Invention

This invention relates to the production and use of a cold plate, which is used to transfer heat.

### Description of the Related Art

Certain electronic devices generate heat as they operate, and this heat has to be removed or dissipated for the device to continue operating properly. Several techniques have been used to cool electronic equipment. Examples include fans, which are used to blow air over electronic equipment. This air serves to convectively cool the electronic equipment with formal ambient air. Other techniques that have been used include liquid cold plates. Liquid cold plates are plates with channels through which liquid flows. The electronic equipment is mounted in contact with a liquid cold plate and the heat generated by the electronic equipment is transferred to the coolant inside the plate. This can provide better cooling than the convective cooling provided by a fan with considerably less flow volume. It can also provide better temperature consistency with less acoustic noise.

Cold plates can be directly affixed to a heat-producing piece of electronic equipment, such as an electronic chip or an insulated grated bipolar transistor (IGBT). Typically, the cold plate includes an inlet and an outlet for liquid coolant flow. The liquid coolant absorbs the heat produced by the electronic equipment, and transfers the absorbed heat to the coolant which then flows out of the cold plate. Many cold plates provide cooling with a relatively low flow of liquid coolant. They can provide a degree of temperature consistency, minimal acoustic noise and the cooling power of liquid coolants.

Several factors impact the performance and desirability of cold plates, and different factors are important for different uses. Some important factors include cost of production and ease of producing relatively large quantities. Cooling efficiency should be high, and cold plates should be securely sealed so as to prevent any leak of liquid coolant onto the electronic equipment being cooled.

In some applications, the coolant may not be particularly clean, which can result in plugging of the cold plate. For example, a cold plate used in an automobile may utilize the anti-freeze liquid for cooling, and the anti-freeze can contain small particulates. In other applications, there may be a phase transfer within a cold plate to help facilitate cooling. It is also possible for a cold plate to be used for heating a component buy replacing the coolant with a heating fluid. One primary difference between a coolant and a heating fluid in one phase heat transfer is the temperature of a coolant is lower than the item being cooled, and the temperature of a heating fluid is higher than the item being cooled.

US2007163749 (A1) discloses in an electrical component package ( 1 ) provided with a liquid-cooled heat exchanger ( 20 ), a main-body plate ( 1 A) of the package and a crowning member ( 5 ) that are composed of metal plates are joined together, forming a hollow part (6) therebetween for use as a liquid-cooled heat exchanger in which a working fluid is sealed. A concavity ( 2 ) for use in mounting an electrical component ( 8 ) to be cooled is formed on the outer surface portion of the main-body plate ( 1 A) of the package disposed opposite to the hollow part ( 6 ). An inner surface portion ( 5 a) that faces into the hollow part ( 6 ) of the main-body plate ( 1 A) of the package is carved out using a carving tool, whereby fins ( 3 ) are formed at a fine pitch on the inner surface portion. Minute channels ( 4 ) for moving the working fluid are formed between the fins.; A flat electrical component package can [therefore] be provided with a liquid-cooled heat exchanger that has excellent heat-radiating functionality.

US2005/199372 (A1) discloses a cold plate having a base member and a cover member connected thereto by friction stir welding and one or more pins or flow channels machined into the base and/or the cover member. The invention also relates to a method of making a cold plate including providing a base member and a cover member, machining one or more pins or flow channels in the base and/or cover members and connecting the base and cover members via friction stir welding.

### BRIEF SUMMARY OF THE INVENTION

The present invention provides a cold plate as detailed in claim 1 and a method according to claim 9. Advantageous features are provided in dependent claims.

The current invention comprises a cold plate and a method of producing the cold plate. The cold plate has an enclosure with an inlet, an outlet, a base, and a lid. The base is formed from a base plate, and the base plate includes an island. A plurality of pins extends from the: island into the enclosure, so a fluid can flow about the pins. The pins can have a spiral shape, where the cross sectional profile of the pins change along the pin length.

### BRIEF DESCRIPTION OF THE SEVERAL VIEWS OF THE DRAWINGS

Figure 1 shows a cooling system using a cold plate.
Figure 2 is an exploded view of one embodiment of a cold plate.
Figure 3 is a cross sectional side view of one embodiment of a cold plate.
Figure 4 is a perspective view of a base plate.
Figure 5 is a perspective view of a base plate with a different pin pattern.
Figure 6 is a partial cross sectional side view of two pins as part of a base plate.
Figure 7 a side view of one pin.
Figure 8 is a perspective view of one pin sectioned into four pieces.
Figure 9 is a perspective view of a tool forming fins in a base plate.
Figure 10 is a side cross sectional view of a tool forming fins in a base plate.
Figure 11 is a side cross sectional view of a tool forming fins at a different angle in a base plate.
Figure 12 is a perspective view of a tool forming a pin from a fin.

### DETAILED DESCRIPTION

Some electronic components are limited by the heat they produce. Cooling can help to increase the utilization of some of these components. Different cooling techniques are more appropriate for different equipment or different circumstances. One cooling method uses fans to blow air over an electronic component for convection cooling. This technique is sample and safe, but does not provide the cooling potential of some other techniques. The utilization of a liquid coolant can provide more efficient cooling, but many electronic components can malfunction when splashed with a liquid, so some can be cautious when using liquid cooling. Nevertheless, liquid cooling can increase the overall efficiency of some electronic components, as well as providing certain other benefits. Secondary benefits can include decreased acoustical noise and superior temperature consistency in the electronic component.

### Heat Transfer Fundamentals

This description will focus on single phase heat transfer. It is recognized that cold plates and other heat transfer devices can be used for two phase cooling, and the invention is not limited to single phase cooling, but this description focuses on single phase heat transfer for simplicity and clarity.

Air or other gases could be used as the cooling medium in a cold plate, but liquids are preferred. Liquid cooling is different than gas cooling for several reasons. For example, liquid are denser than gases so more thermal mass is available to absorb heat from the electronic equipment. Also, liquids generally have higher thermal conductivities so heat will transfer into and through the liquid more rapidly than heat will transfer into and through a gas. Furthermore, liquids tend to have a higher specific heat than gases so a set quantity of liquid will absorb and transfer more heat than a comparable amount of gas. Because of this, when electronic equipment is utilized which produces large amounts of heat, many manufacturers may choose liquid cooling devices.

Reducing resistance to heat flow improves the efficiency of a heat transfer device. Two significant forms of resistance to heat flow include resistance through one material and resistance across an interface between two separate components or parts. Resistance to heat flow through a single material is minimized if the material is a heat conductor, instead of a heat insulator. Metals are usually relatively good conductors, and they can be formed and shaped in many ways. Copper is a metal which readily conducts heat, and it is relativity malleable, so copper is often used in cold plates. However, other materials can also be used, such as aluminum, titanium, steel, gold, or even non-metallic materials like graphite or ceramics.

Another source of resistance to heat flow is at the interface between two components or parts. Typically, when heat flows from a first component to another component which contacts the first, there is resistance to heat flow between the two components. Forming a heat transfer device from one solid substrate can help improve heat transfer. If one were to produce one heat transfer component separately and then affix that component to another, there would be a resistance to heat flow at the joint between the two components. This is true even if the separate components were made from the same material, such as copper. Forming a heat transfer device from fewer components can improve heat transfer. When one piece is formed from another so there is no joint between the two, the pieces are said to be monolithic in this description.

Heat flow can also be improved by increasing the surface area where two different materials contact each other. When a liquid flows over a solid, heat is transferred between the two materials where the liquid contacts the solid. Increasing the surface area where the liquid contacts the solid is another way to decrease resistance to heat transfer, and increase the efficiency of a heat transfer device.

In some cases, liquids will flow across a solid in what is referred to as laminar flows. In laminar flow, the layer of liquid directly contacting the solid surface remains essentially stationary at the solid surface. The layer of liquid directly above that layer moves very gradually across the first layer. The next layer up moves a little more swiftly, etc., such that the highest flow rate will be at a point relatively far from the solid surface. The lowest flow rate, which is essentially zero, will be at the solid surface. Each different layer of liquid which is sliding over the adjacent layers provides its own resistance to heat flow. Therefore, if the liquid can be mixed during flow, the liquid directly contacting the solid surface can absorb heat from the solid surface and then be mixed with the entire body of cooling liquid to spread the absorbed heat into the liquid more rapidly.

Turbulent flow causes liquids to mix as they flow across a solid surface, as opposed to laminar flow. This tends to keep the liquid in contact with the solid surface cooler, which facilitates a faster transfer of heat from the solid surface to the liquid. Some things which tend to increase turbulent flow include faster flow rates, uneven surfaces, projections into a flowing liquid, and various obstructions that force a liquid to change path and flow another way. To maximize turbulence, one can include sharp bends, twisting edges, curved pillars, and any of a wide variety of flow obstructions that cause rapid change in the direction of flow of a liquid. Many structures which increase turbulence can also increase pressure drop across a cold plate. Increased pressure drop can lower the flow rate, so a balance must be observed to ensure efficient heat transfer Obstructions which tend to increase the amount of fluid flow close to the solid surface also tends to increase heat transfer, because this reduces the thickness of any stagnant liquid layer at the solid liquid interface, and it also reduces the distance heated liquid has to travel to intermix with the main body of cooling liquid.

### Cold Plate Cooling System

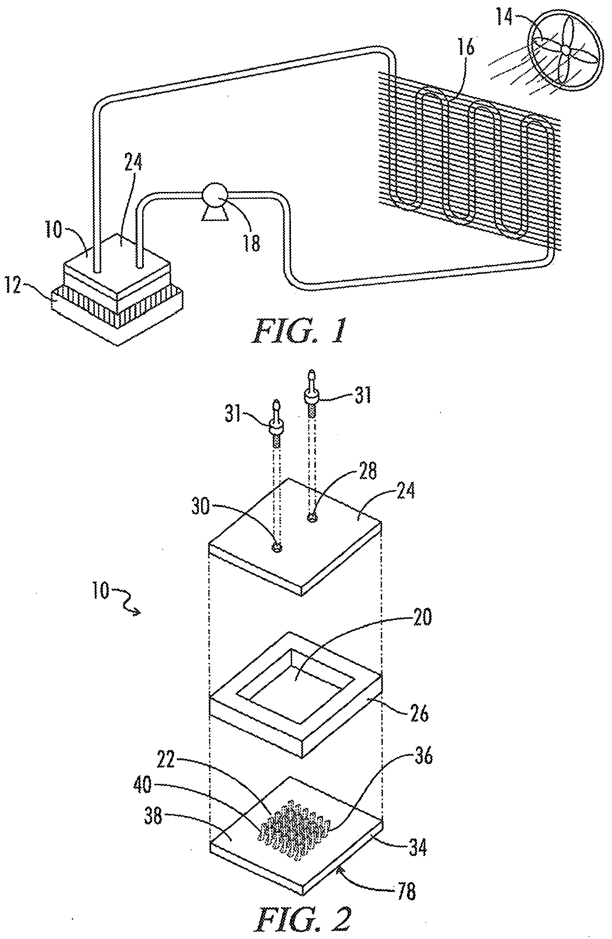

A cold plate **10** can be connected to an electronic component **12** or some other device to help cool the electronic component **12** or other device, as seen in Figure 1. The cold plate **10** could also be used to heat a device in the same manner as cooling a device, but this description is directed towards cooling for simplicity and clarity. A cooling liquid, also referred to as coolant, is used to absorb heat from a heat source, such as an electronic component **12**. After the coolant has absorbed the heat, it can be circulated to a different location where the coolant itself is cooled before being re-used for cooling. In one embodiment, a fan **14** blows cool air over a connective cooling device **16**, similar to an automobile radiator, through which the coolant is circulated. A heat exchanger using facility water or other cooling systems could be used in place of the convective cooling device **16**. It is also possible to simply move the heated fluid through a cooler area, such as by pumping the coolant through tubes exposed to air which is cooler than the coolant.

A pump **18** or other flow-inducing device can circulate the coolant through the cold plate **10**. The cold plate **10** is affixed to an electronic component **12**, such as with adhesive, sonic welding, brazing, soldering, diffusion bonding, or any other appropriate technique. Certain adhesives readily conduct heat, and can help minimize resistance to heat flow. Direct connection of the cold plate **10** to the electronic component **12** can minimize resistance to heat transfer. Use of a thermo-electric cooler between the cold plate **10** and the electronic component **12** can improve performance, but thermo-electric coolers are beyond this discussion. In one embodiment, the heat generated by the electronic component **12** is transferred to the coolant in the plate **10**, and the coolant is then pumped to the convective cooling device **16** which is cooled with air from a fan **14**. It is possible to connect a plurality of cold plates **10** or other heat exchanger devices in a single loop, so several electronic components **12** or other heat producing devices can be cooled with a single pump **18** and convective cooling device **16**. For example, an automobile could use the water pump **18** to deliver antifreeze (a coolant) through the engine block to cool the engine, and also to deliver antifreeze to a water block **10** for cooling an electronic component **12**.

Evaporative cooling can also be used, where a liquid is evaporated by the heat from the electronic component **12** or other heat source. Typically, the liquid is evaporated into a gas in an evaporator, and then the gas is re-condensed into a liquid in a condenser. It is also possible for the liquid to be evaporated and discharged from the system. A cold plate **10** can be used as an evaporator and/or a condenser. Many materials can be used as the coolant, including water, a water and glycol mixture, chloro fluoro carbons (CFCs), hydro chloro fluoro carbons (HCFCs), ammonia, brine solutions, oils, and many other materials.

### Cold Plate

The cold plate **10** includes several structural components, as seen in Figures 2, 3, and 4, with continuing reference to Figure 1. Coolant in the cold plate **10** flows through an enclosure **20**, and the enclosure **20** has a base **22** and a lid **24**. The enclosure **20** will also typically include side walls **26**. The base **22** is at the bottom of the enclosure **10**, and the lid **24** is at the top. The side walls **26** may be incorporated as part of a single structure used to make the lid **24**, or the side walls **26** can be a separate structure, or the side walls may be a part of the base **20**. It is also possible for the base **22** and lid **24** to gradually slope together, so there is no sharp demarcation between the side walls **26** and the base **22** and/or lid **24**. The enclosure **20** can be almost any shape, so if the enclosure is round or cylindrical, the side walls **26** could be one continuous wall.

Coolant or other fluids enter and exit the enclosure **20** through an inlet **28** and an outlet **30**. The inlet **28** and/or outlet **30** may penetrate the lid **24**, a side wall **26**, or the base. **22**, as long as the inlet **28** and outlet **30** allow for fluid to enter and exit the enclosure **20**. The inlet **28** and outlet **30 are** in fluid communication through the enclosure **20**, so fluid enters the enclosure **20** through the inlet **28**, travels through the enclosure **20**, and then exits the enclosure **20** through the outlet **30**. This direction of flow could also be reversed. It is also possible for there to be more than one inlet **28**, and/or more than one outlet **28**. A nozzle **31** or similar device can be connected to the cold plate **10** at the inlet **28** and/or outlet **30** to facilitate fluid flow.

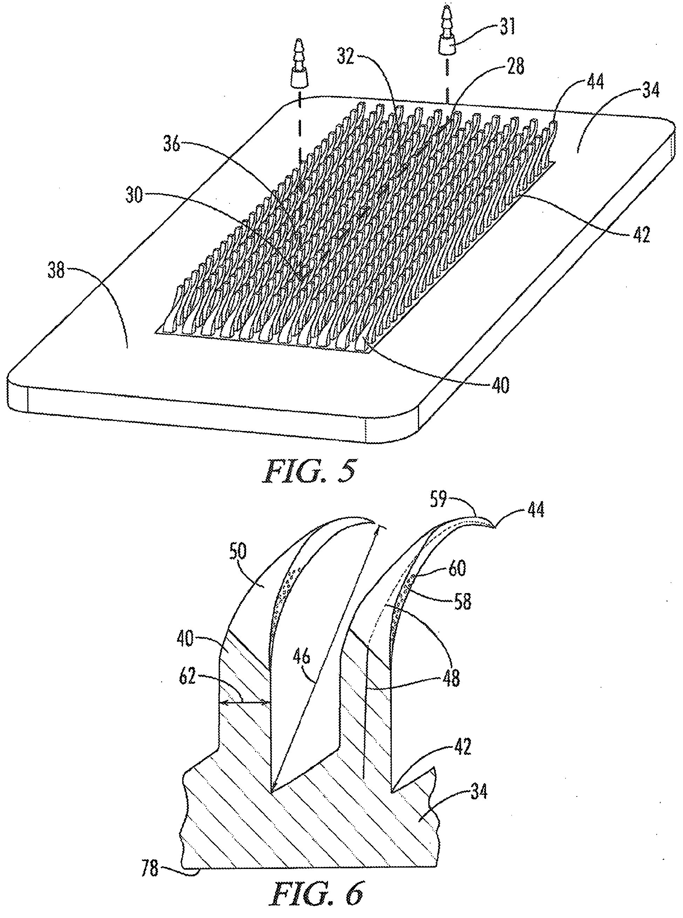

The positioning of the inlet **28** and outlet **28** influence the flow pattern through the enclosure **20**. A flow line **32** is defined as a line straight between the inlet **28** and the outlet **30**, as seen in Figure 5, with continuing reference to Figures 1-4. In some embodiments, the flow pattern will tend to follow the flow line **32**, but some structures within the enclosure **20** can alter the flow pattern. The angle at which the inlet **28** and/or outlet **30** penetrate into the enclosure **20** can also influence the flow pattern, because the inlet **28** can serve as a jet to direct flow, and the outlet can serve as a drain to direct flow. The location of the inlet **28** and/or outlet **30** can also influence the flow pattern, and this can be utilized with the angle at which the inlet **28** and/or outlet **30** penetrate the enclosure **20** to establish a more desirable flow pattern. In some embodiments, a flow pattern which covers most of the base **22** is desired to maximize the area being cooled by flowing fluid.

The base **22** of the enclosure **20** is formed from a base plate **34.** The base plate **34** includes an island **36**, which is on the side of the base plate **34** facing into the enclosure **20**. In some embodiments, a base plate back side **78**, or the side of the base plate **34** opposite the island **36**, is attached to the electronic component **12** or other heat producing device. It is also possible to attach a different part of the cold plate **10** to a heat producing device, if desired.

The base plate **34** can include an attachment area **38** around the island **36** for attaching side walls **26** and/or a lid **24.** The connection of the base plate **34** to the lid **24** or side walls **26** should be water tight, to prevent the leakage of liquids (if the cooling fluid is a liquid). A smooth surface for the attachment area **38** can facilitate a water wight connection, but other surfaces may be useful as well. The attachment area **38** could include a groove with a matching lip on the lid **24** or side wall **26**, or a roughed surface for use with an adhesive, or any of a wide variety of other options. In some embodiments, the lid **24** and/or side walls **26** slide completely around the base plate **34**, so the attachment area **38** can be on a sideways facing surface of the base plate **34** which is perpendicular to the surface of the island **36.** In other embodiments, the attachment area **38** can be raised up so a flat lid **24** can complete the enclosure **20.** A wide variety of design options can be used for the attachment area **38.**

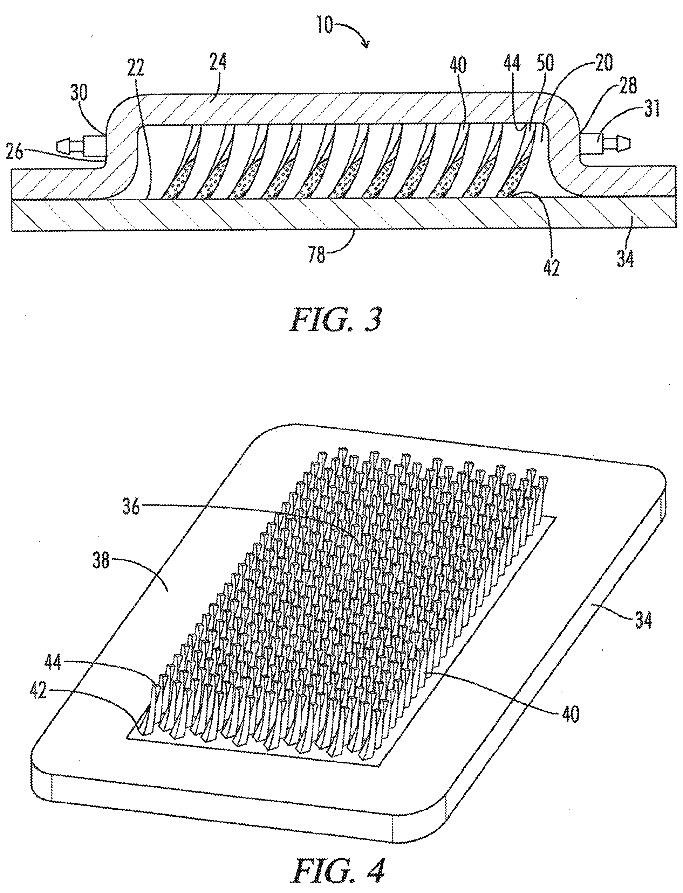

A plurality of pins **40** extend from the island **36** upward toward the lid **24.** The pins **40** can extend all the way to the lid **24,** so the pins actually touch the lid **24,** or the pins **40** can extend to a point short of the lid **24,** so there is a gap between the pins **40** and the lid **24.** The pins **40** in the cold plate **10** are arranged in some pattern. The pattern can be random, or the pattern can be ordered. In one embodiment, the pins **40** are aligned along lines parallel with the flow line **32,** as shown in Figure 5. This pattern is referred to as the aligned pattern Having the pins **40** aligned with the flow line **32** tends to result in the coolant flowing between different rows of pins **40.** This flow can help to reduce pressure drop in the cold plate **10**. The spiral of the pins **40** in the aligned pattern can provide a cold plate **10** with some similarities to a cold plate **10** with a wavy fin design. In an alternate embodiments, the pins **10** are aligned in rows which cross the flow line **32,** as shown in Figure 4. This pattern is referred to as the staggered pattern. The rows of pins **10** can be set at almost any angle to the flow line **32,** such as a forty five degree angle, a thirty degree angle, or essentially any other angle. In the staggered pattern, the fluid is forced to flow around the staggered pins, so the fluid can not flow in a straight line parallel with the flow line **32.** This tends to cause a zig zag flow pattern, which tends to increase turbulence and also increase pressure drop across the cold plate **10**.

### Pin Shape

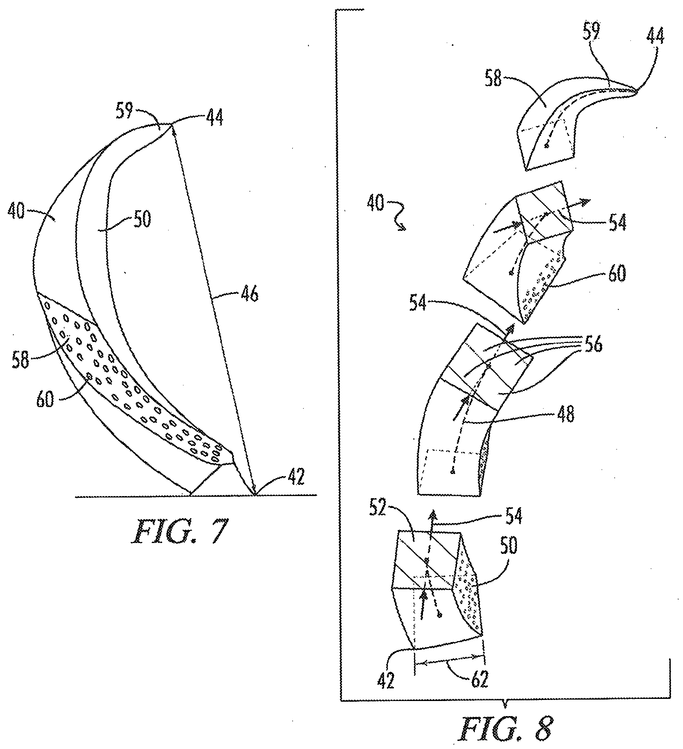

The pins **40** have a shape, and the shape can effect the heat transfer efficiency of the cold plate **10**, as seen in Figures 6, 7, and 8, with continuing reference to Figures 1-5. The pins **40** have a pin bottom **42**, which is where the pin **40** attaches to the island **36** of the base plate **34,** and the pins **40** have a top **44** at the opposite end of the pin **40** from the pin bottom **42.** So, the top **44** is generally the portion of the pin **40** closest to the lid **24**. A pin length **46** is measured from the pin bottom **42** to the pin top **44,** and a pin axis **48** runs down the center portion of the pin **40. The axis 48** runs through the center of the pin **40,** so the taxis **48** would be at the center point of any cross section of the pin **40.** The pin **40** also includes a side surface **50**, which is the outer surface of the pin **40** on the side, running from the bottom **42** to the top **44**.

Each pin **40** has a cross sectional profile **52**, where a cross section is perpendicular to the axis **48**. The cross sectional profile **52** is the shape of the cross section. This cross sectional profile **52** can be many different shapes, but in some embodiments it is generally a quadrilateral. Each cross sectional profile **52** also has a cross sectional orientation **54,** which refers to the way the cross section is facing. A quadrilateral, or any other shape, does not have a clear, set front end, but any side or point along the perimeter of the cross section can be selected as a point of reference for the cross sectional orientation **54.** The cross sectional profile **52** can change along the pin length **46,** so the size or general shape is not necessarily fixed and constant for the entire length **46** of the pin **40.** The cross section also has a cross sectional area **56,** which is the area of the cross section. The cross sectional area **56** can also vary along the length **46** of the pin **40,** so the pin **40** can get fatter or skinner at different points along the pin length **46.**

The pins **40** of the current invention have some specific structural aspects. In one embodiment, the pins **40** have a spiral shape. The cross sectional orientation **54** changes along the pin length **46,** and the point of reference used for the cross sectional orientation **54** tends to consistently move in the same direction from the pin bottom **42** to the top **44**. The cross sectional orientation **54** may not change along the entire pin length **46,** but it does change along at least a portion of the pin length **46.** This gives a spiral appearance to at least a portion of the pin **40.** In other embodiments, the point of reference may move in one direction for one portion of the pin **40,** move another direction for a different portion of the pin **40,** and may possible not move for yet a different portion of the pin **40.** A polyhedral shape, such as a quadrilateral, results in edges along the pin side surface **50.** The varying cross sectional orientation **54** along the pin length **46** results in the edges changing position along the pin length **46.** This variation in the edges can increase turbulence in fluids flowing around the pin **40**, and may therefore improve the efficiency of the cold plate **10**. The incline angle of the pin **40** can also be manipulated by presetting an angle of a cutting tool used in the formation of the pin **40,** as discussed in greater detail below.

The pin **40** may also have a bend in some embodiments. The pin **40** is said to be bent when the axis **48** bends along the pin length **46.** Because of possible changes in the cross sectional profile **52** of the pin along the pin length **46,** it is possible for one side of a pin **40** to appear relatively straight and the other side to appear bent, but the axis **48** of the pin **40** still bends along the pin length **46**. In some embodiments, the bent shape of the pin **40** appears similar to a banana, however the appearance of the pin **40** varies in different embodiments. In some embodiments, there is a "fish hook" **59** present near the pin top **44,** where the fish hook **59** is a more sharply bent portion of the pin **40;** however in other embodiments the fish hook shape is not present. The fish hook **59** looks somewhat like the stem of a banana. The bent shape of the pin **40** presents an obstacle with a varying shape for fluid to flow around, which may increase turbulence in the cold plate **10**. The bent shape can direct fluid flow up and/or down to further vary the fluid flow pattern, and thereby possibly increase turbulence. Fluid flow directed downward toward the base plate **34** comes nearer to what may be the hottest part of the cold plate **10**. This increased flow nearer to the pin bottom **42** may increase heat transfer. There can be a larger temperature differential between the solid material of the cold plate **10** near the pin bottom **42** and mixed coolant flowing nearby, and an increased temperature differential can increase the overall cold plate efficiency.

In other embodiments, the pin **40** can have at least two different textures **58** on the side surface **50.** At least one of these textures **58** includes dimples **60,** and can appear somewhat like an orange peel. The dimples **60** are indentations extending into the pin **40** from the surface for at least some distance. The different textures **58** can be on different faces of the quadrilateral or polyhedral shape of the pin **40.** In some embodiments, the side surface **50** will include at least three different textures, and there can be two different textures **58** along one face of the polyhedral shape of the pin **40**. The different surface textures **58** provide additional structure which can cause turbulence and help increase heat transfer. The dimples **60** provide varying surface structure which does tend to increase turbulence in fluid flowing past the pin **10**, and a change in texture may also cause turbulence.

The pin **40** may also have a varying thickness along the pin length **46** in some embodiments. There may be a taper to the pin **40** at the pin bottom **42,** so the thickness of the pin **40** is decreasing closer to the pin bottom **42**. Stated more technically, the cross sectional area **56** can increase with an increasing distance from the pin bottom **42** for a least a portion of the pin **40.** This is consistent with the banana shape of the pin **40**, because a banana tends to taper near the end of the banana opposite the stem. This can result in a pin **40** which is thicker near the middle or top **44** than at the pin bottom **42.** Providing more room for fluid to flow near the pin bottom **42** than higher up on the pin **40** urges fluid to flow closer to pin bottom **42** and the base plate **34**. The base plate **34** can be connected to the heat producing item to be cooled, so increased fluid flow near the base plate **34** can increase heat transfer efficiency. In other embodiments, the pin **40** does not become thicker further from the bottom **42**, so any taper is present is a thinning of the pin **40** progressing from the bottom **42** to the top **44**.

In some embodiments, the pin **40** can be monolithic with the base plate **34**, which means there is no joint between the pin **40** and base plate **34**. This can be accomplished by forming the pin **40** directly from the base plate **34**, instead of forming the pin **40** separately and then securing the pin **40** to the base plate **34** in some manner. Having the pin **40** monolithic with the base plate **34** can increase heat transfer by reducing the resistance to heat flow from the base plate **34** up the pin **40**. As heat flows up the pin **40**, fluid flows past the pin **40,** absorbs the heat from the pin **40**, and increases the overall heat transfer efficiency of the cold plate **10**. The pins **40** provide additional surface area for heat transfer from the base plate **34,** and a low resistance to heat flow between the base plate **34** and the pins **40** increases overall heat transfer efficiency.

The pins **40** can include an aspect ratio of twenty to one in some embodiments, where the pin length **46** is twenty times the distance across the pin **40,** or pin width **62**. Heat transfer is increased by increasing the aspect ratio, because a longer pin **40** with the same width **62** tends to have more surface area, and increasing surface area tends to increase heat transfer efficiency.

The various aspects of the pin shape described above can be present in the pins **40** in isolation, or any combination. This includes the quadrilateral cross section, the spiral shape, the bent shape, the plurality of textures, the taper shape, the monolithic connection to the base plate, the incline angle, and the aspect ratio. Each pin **40** may include only one of these structures, or any combination of the structures, depending on manufacturing techniques and heat transfer properties desired, amongst other factors.

### Production Method of the Base Plate

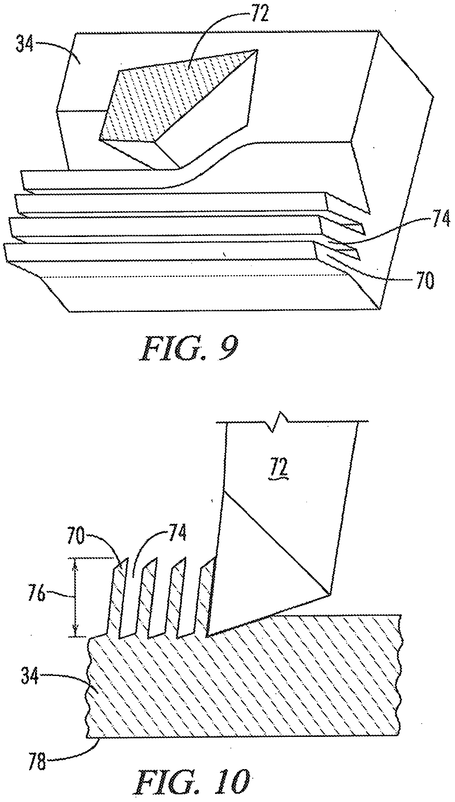

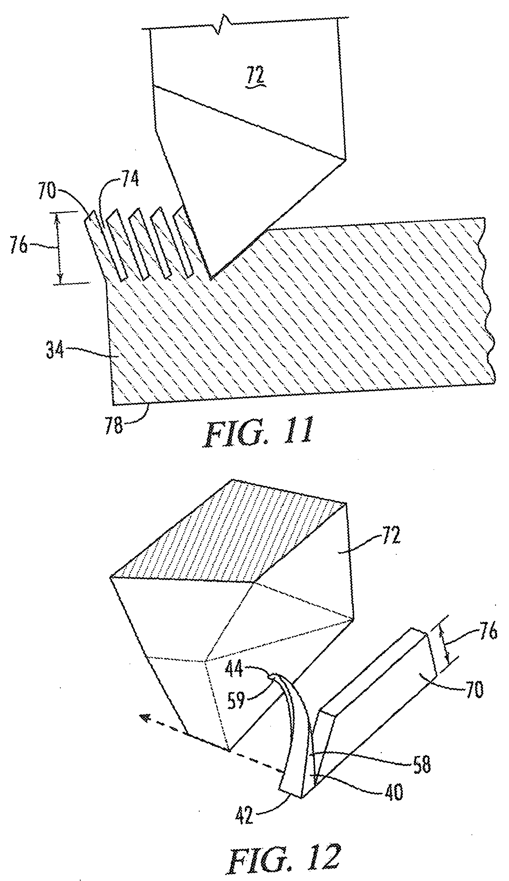

The current invention also includes a method of producing the cold plate **10**, as seen in Figures 9-12, with continuing reference to Figures 1-8. The cold plate **10** is constructed by preparing a base plate **34,** and attaching a lid **24** to the base plate **34.** There can be other structures included as well, such as separate side walls **26.** The lid **24** is attached to the base plate **34** such that there is an enclosure **20** positioned between the lid **24** and base plate **34**. Standard production techniques can be used to produce the lid **24** and side walls **26**. This includes stamping, cutting, casting, metal injection moulding, machining and other techniques. The lid **24** and base plate **34** can also be joined by many standard techniques, such as brazing, welding, soldering, gluing, and other connection methods.

The production of the base plate **34** requires additional steps. The pins **40** are produced by first slicing fins **70** into the base plate **34,** and then performing a second set of slices across the fins **70.** The second set of slices essentially cross cut the fins, and this cross cutting produces the pins **40.** One process used to slice the base plate **34** is called micro deformation technology (MDT), and it is described in U.S. Patent 5,775,187, issued July 7, 1998, which is hereby incorporated in full into this description. In this process, a base plate **34** is sliced with a tool **72** without removing material from the base plate **34.** The MDT process is different than a saw or router, which removes material as cuts are made, and is more similar to the cutting of meat with a knife.

The slicing of the base plate **34** is done with the tool **72.** As the tool **72** contacts the material of the base plate **34,** a fin **70** is cut from the main block of material. This forms a channel **74** between adjacent fins **70,** and can be done without removing material from the base plate **34**. Preferably, there are no shavings produced in the formation of the fins **70**. The tool **72** cuts fins **70** in to the base plate **34,** and the space produced as the tool **72** passes through the base plate **34** material deforms and forces material in the fins **70** upwards. This cutting and deformation of the base plate **34** material causes the fins **70** to rise to a fin height **76** which is higher than the original base plate **34**. The MDT cutting tool design, the depth of cutting, the width of the fins **70** and the channel **74** are factors which effect the fin height **76**. This process is repeated until a bed of fins **70** has been produced.

The pins **40** are made by slicing across the fins **70**. The second set of slices can also uses the MDT method, and raises the pins **40** to a length **46** greater than the fin height **76**. As the slices are made, no material is removed from the base plate **34**, so the moved material is instead directed into the remaining pin **40** or fin **70.** This causes the remaining pin **40** or fin **70** raise to a height, higher than the material from which the pin **40** or fin **70** was cut. The second set of slices can be made at an angle other than ninety degrees to the fins **70**, but it has been found that the pin length **46** tends to vary when angles other than about ninety degrees are used. A cold plate **10** can be made with varying pin lengths **46** if desired, or the pin lengths **46** can be kept more consistent by making the second set of slices at about ninety degrees to the fins **70.** In an alternate embodiment, the fins **70** are made without using the MDT process, and the pins **40** are then formed from the fins **70** using the MDT process. In another alternate embodiment, the fins **70** are made using the MDT process, and the pins **40** are then formed from the fins **70** using a conventional cutting process. This can generate a non-spiral structure of pins **40**.

The technique of cross slicing the base plate **34** to produce the pins **40** contributes to the final shape of the pins **40.** The first slice makes a fin **70** with two flat sides, and the second slice tends to make a pin **40** with two more flat sides, for a total of four relatively flat sides. The four relatively flat sides produce the quadrilateral cross sectional profile **52** for the pin **40.** The quadrilateral cross sectional profile **52** provides edges between different side surfaces **50** which tend to increase turbulence in fluid flowing over those edges. Additionally, the slicing of the pins **40** from the base plate **34** results in the pins **40** being monolithic with the base plate **34,** which improves heat transfer as discussed above. Additionally, the incline angle of the pin **40** and/or the fin **70** can be manipulated by the angle of the tool **72** as the slices are made. A modification of the incline angle of the fin **70** can change the incline angle of the pin **40**.

The cutting action of the tool **72** on the material of the base plate **34** provides different textures to the material as it is cut. The surface which is cut and pushed up to form a fin **70** or pin **40** takes the texture of the cutting surface of the tool **72**, which can be very smooth. The base plate surface on the opposite side of the tool simply has material cut away from it, and this tends to produce an orange peel texture **58,** or a texture including a plurality of dimples **60,** This results in the two surfaces facing each other across a channel **74** having different textures **58.** The original surface texture **58** of the base plate **34** before any slices are made also remains on a portion of the pin **40.** The original base plate surface is cut and lifted up in the fin **70**, and then it is cut and lifted again in the second set of slices to form the pin **40**. This surface texture **58** remains on a portion of the pin **40,** which can provide a third texture **58** on the pin. The different textures **58** on the pin side surfaces **50** can increase turbulence by providing changes in the fluid flow pattern. The dimples **60** in particular tend to cause swirls, mixing, and turbulence more so than a smooth surface.

Slicing the pins **40** from fins **70** provides the bent shape of the pins **40,** and can also provide the spiral shape of the pins **70.** The fins **40** are free standing, so the cutting action of the tool **72** tends to bend the pin **40** over as it is cut. The fin **70** is more stable near the pin bottom **42,** because this portion is attached to the base plate **34.** The higher portions of the fin **70** do not have the support of the lower portions, and these higher portions tend to be bent over as the pin **40** is cut and formed. The tool **72** is only cutting on one side of the pin **40** as it is formed, so the bending force is only applied to one side of the pin **40.** Because the bending force is only applied to one side of the pin **40**, part of the bending force can serve to twist the pin **40,** resulting in a spiral effect. The bent and spiral shaped pin **40** may increase turbulent flow and urge flow closer to the base plate **34**, which can increase heat transfer efficiency as discussed above. One method which can help keep the flow path of the cold plate **10** more fully open is to slice the fins **70** in essentially a perpendicular direction to the final flow line **32,** and then make the secondary slice to form the pins **40** essentially parallel to the flow line **32.**

The taper and banana shape of the pin **40** can also result from the slicing of the MDT method. As a cut is made, the newly formed fin **70** or pin **40** is pushed upward to accommodate the material moved by the cutting action. The material near the pin bottom **42** is pushed up into the body of the pin **40,** and can result in a thicker central portion of the pin **40.** This thicker central portion provides the tapered shape of the pin bottom **42,** and can also provide an opposite tapered shape near the pin top **44**. The tool **72** can also catch the top portion of the fin **70** as it passes, and more readily mold this thinner material such that the fish hook **59** is formed. The fish hook **59** can be eliminated by trimming off the tip of the fin **70** prior to the second cutting process, if desired, or the fish hook **59** can be left in place. This fin trimming process also helps to control the final pin length 46.

The dual cross slicing to first form the fins **70**, and then to form the pins **40,** pushed material into the pin **40.** This technique has been used to produce aspect ratios of twenty to one, as described above. The slices with the tool **72** can be done using known techniques with a wide variety of machines, including but not limited to a milling machine, a shaper, or even a lathe. The slicing of a base plate **34** can provide an efficient, relatively low cost method of producing pins **40** for a cold plate **10**.

### Production Method of the Cold plate.

After an island **36** of pins **40** are formed, the base plate **34** can be prepared for assembly into a cold plate **10**. The lid **24** is attached to the base plate **34**, perhaps through a side wall **26** piece, to form the enclosure **20.** An inlet **28** and an outlet **30** penetrate into the enclosure **20** to provide access for a coolant or other fluid. The inlet **28** and outlet **30** can be made before the base plate **34** and lid **24** are assembled, or after. Nozzles **31** can be attached to the inlet **28** and/or outlet **30** to facilitate fluid flow, and the shape of the inlet **28** and outlet **30** can vary. For example, the inlet **28** and outlet **30** can be a round hole, a square hole, a manifold covering the entire side of the cold plate **10,** or any of a wide variety of other shapes. The inlet **28** and outlet **30** can be drilled, stamped, cut, or produced in a number of known techniques.

To prepare the base plate **34** to receive the lid **24** or side wall **26**, an attachment area **38** is made. The attachment area **38** can be made in several different ways. In one embodiment, the entire upper surface of the base plate **34** is formed into pins **40,** and the side surface of the base plate **34** is used as an attachment area **38.** In an alternate embodiment, the attachment area **38** is formed on the outer edges of the upper surface of the base plate **34,** with the island **36** of pins **40** positioned inside of the attachment area **38.** In one embodiment, the attachment area **38** can be formed by machining after the entire upper surface of the base plate **34** is formed into pins **40. in** an alternate embodiment, the attachment area **38** is machined to a lower level than the island **36** prior to forming the pins **40,** and the slices of the tool **72** are set to pass over the attachment area **38.** In this way, the island **36** of pins **40** is formed inside the attachment area **38** without disrupting the surface of the attachment area **38**. A wide variety of other options using known techniques can also be used to produce the attachment area **38.** The attachment area **38** can take many forms, depending on the type of attachment to be made, as discussed above.

The alignment of the pins **40** in the cold plate **10** can vary, including an aligned pattern or a staggered pattern. For a rectangular cold plate **10,** the aligned pattern can be made by slicing the fins **70** and pins **40** in slices perpendicular to the edge of a rectangular base plate **34.** The cold plate **10** is then constructed and with the inlet **28** and outlet **30** centered along one edge of the base plate **34.** The staggered pin pattern can be made with the same base plate **34** as used for the aligned pattern, where the corners of the base plate **34** are removed to produce new edges. These new edges are no longer in line with the pins **40** sliced into the base plate, and the cold plate **10** can be constructed as before. In an alternative embodiment, the staggered pin pattern can be made by slicing the fins **70** and pins **40** at an angle to the edge of the base plate **34.** The cross slices for the fins **70** and pins **40** can still be at ninety degrees, but the resulting pin pattern is not in rows parallel and perpendicular to the edges of the base plate **34.** Other methods and techniques can also be used to produce different patterns of pins **40**.

The back side **78** of the base plate **34,** which is opposite the pins **40,** may need to be very flat to make a good thermal connection with the electronic component **12** or other item to be cooled. It may be desirable to take steps to flatten the base plate back side **78** before the cold plate **10** is used. This back side **78** can be flattened in several ways, and it can be flattened before or after the pins **40** are formed. In some embodiments, the back side **78** is flattened after the pins **40** are formed to correct any warp or bending which may have occurred as the pins **40** were formed. Known techniques can be used to produce a flat back side **78** of the base plate **34.** In embodiments where the back side **78** of the base plate **34** is flattened after the pins **40** are formed, measures can be taken to prevent damage to the pins **40.** This can include a jig to suspend the pins **40** while machining the back side **78** of the base plate **34**, and/or a vacuum system may be employed to hold the base plate **34** for subsequent flattening.

### Dimensions, Use, and Example

The cold plate **10** can be used for many different purposes. Different designs are better suited to different purposes. For example, if the cold plate **10** is used in motor vesicle with engine coolant fluid, the cold plate **10** should be designed to withstand some particulates in the coolant, If the cold plate **10** is used in a computer with a very clean, filtered coolant, particulate concerns are not as important. The dimensions discussed below can be used with a coolant having particulates up to one millimeter in diameter.

In one embodiment of the cold plate **10,** the enclosure **20** is sized so the pins 40 essentially contact the lid **24.** The pins **40** are approximately five millimeters high and approximately one millimeter wide. The gap between neighboring pins **40** is approximately one millimeter, and the total cold plate size is approximately fifteen centimeters by fifteen centimeters.

The performance of three different cold plates **10** was modeled with a computer simulation. In the model, the first cold plate **10** include fins **70,** the second cold plate **10** included pins **40** with an aligned pattern, and the third cold plate **10** included pins **40** with a staggered pattern. The pins **40** in the model include spirals and bends as described in this description.

In each of the three computer models, the coolant was ethylene glycol with a density of 1,027 kilograms per cubic meter (kg/m³), a dynamic viscosity of 0.00169 Pascal seconds (Pa * s), a specific heat of 3,300 joules / kilogram degree Kelvin (J/(kg * K)), and a thermal conductivity of 0.388 watts per meter degree Kelvin (W/(m * K)). The flow rate of the coolant through the cold plates 10 was five liters per minute (l/min), and the temperature of the coolant at the inlet **28** was twenty degrees centigrade (C). The heat source was three components generating one hundred sixty six watts (w) each, where each component has an area of fifteen by twelve millimeter (mm), for a total of approximately five hundred watts (w). The coolant flowed sequentially past each heat source.

The specific structure of the cold plates **10** was used in the computer model, and each cold plate **10** had the same length and width. The first cold plate **10** with fins **70** had ten fins per inch or about four fins per centimeter, with a fin thickness of one millimeter, a fin height of four point seven millimeters, and a gap between neighboring fins **70** of one millimeter. The second cold plate **10** with pins **40** in an aligned pattern had ten pins per inch or about four pins per centimeter, a pin thickness of one millimeter, a pin height of four point seven millimeters, and a gap between neighboring pins **40** of one millimeter. The third could plate **10** with pins **40** in a staggered patter had ten pins per inch or about four pins per centimeter, a pin thickness of one millimeter, a pin height of four point seven millimeters, and a gap between neighboring pins **40** of one millimeter.

The model calculated the steady state temperature of each heat source. The coolant flowed past the three heat sources sequentially, so each heat source increased the temperature of the coolant as the coolant passed. Therefore, the first heat source, which was closest to the inlet **28,** was cooled by the coldest coolant, and reached the coldest steady state temperature. The third heat source was cooled by coolant that had been warmed by the first two heat sources, so the third heat source reached the hottest steady state temperature. The second heat source was between the first and third heat sources, so the second heat source reached a steady state temperature between that of the first and third heat source. The steady state temperatures are listed in the table below in degrees centigrade. The computer model also calculated the pressure drop across each cold place **10,** and that value is listed below in millimeter of mercury.

| Cold Plate Number | First Heat Source | Second Heat Source | Third Heat Source | Pressure Drop |
|---|---|---|---|---|
| First (fins) | 40.9 | 43.2 | 43.5 | 79 |
| Second (aligned pins) | 35.3 | 37.8 | 38.9 | 96 |
| Third (staggered pins) | 31.4 | 33.8 | 34.8 | 114 |

This model shows the use of pins **40** can increase heat transfer efficiency over the use of fins **70.** Developing a better pin **40** may increase the heat transfer efficiency even more.

While the invention has been described with respect to a limited number of embodiments, those skilled in the art, having the benefit of this disclosure, will appreciate that other embodiments can be devised which do not depart from the scope of the invention as disclosed here.

## Claims

1. A cold plate (10) comprising:
an enclosure (20) having a base (22), a lid (24), an inlet (28) and an outlet (30);
a base plate (34) forming the enclosure base (22), where the base plate (34) includes an island (36); and
a plurality of pins (40) within the enclosure (20) extending from the base plate (34) toward the enclosure lid (24), where each pin (40) has a length (46) and a cross sectional profile (52) with an orientation (54), and where the cross sectional profile orientation (54) changes along the pin length (46) **characterized in that** the pin (40) has a spiral appearance for at least a portion of the pin length (46).

2. The cold plate (10) of claim 1 where the pin (40) has an axis (48), a bottom (42) and a top (44), and the pin axis (48) bends between the bottom (42) and the top (44).

3. The cold plate (10) of claim 1 where the pin (40) has a cross sectional area and a bottom (42) where the pin (40) connects to the base plate (34), and for at least some portion of the pin (40) the cross sectional area increases with an increased distance from the pin bottom (42), and where the pin (40) is monolithic with the base plate (34).

4. The cold plate (10) of claim 1 where the pin (40) has side surfaces (50) with at least two different textures (58) on the side surfaces (50), and where at least one texture (58) includes a plurality of dimples (60).

5. The cold plate (10) of claim 4 where the pin (40) has at least three different textures (58) on the side surface (50).

6. The cold plate (10) of claim 1 where the pin (40) has a width (62) perpendicular to the length (46), and the pin (40) has an aspect ratio of twenty to one, where the aspect ratio is the ratio of the pin length (46) to the pin width (62).

7. The cold plate (10) of claim 1 including a flow line (32) between the inlet (28) and outlet (30), and where the pins (40) are aligned essentially parallel to the flow line (32).

8. The cold plate (10) of claim 1 where the pin (40) is monolithic with the base plate (34).

9. A method of producing the cold plate (10) of claim 1 comprising:
slicing a base plate (34) to form a plurality of fins (70);
cross-slicing the base plate (34) after the fins (70) are formed to form a plurality of pins (40);
attaching a cover to the base plate (34) such that the plurality of pins (40) are contained within an enclosure (20) between the cover and the base plate (34); and
forming an inlet (28) and an outlet (30) to the enclosure (20).

10. The method of claim 9 where the base plate (34) is sliced such that a pin axis (48) bends along a length (46) of the pin (40).

11. The method of claim 9 where the base plate (34) is sliced without removing material so the fins (70) elevate from the base plate (34).

12. The method of claim 9 where the base plate (34) is sliced without removing material so the pins (40) elevate from the fins (70).

13. The method of claim 9 where the base plate (34) is sliced with a tool to produce at least two textures (58) on a side surface (50) of the pins (40).

14. The method of claim 13 where at least one texture (58) of the side surface (50) includes a plurality of dimples (60).

15. The method of claim 9 where the base plate (34) is sliced such that a lower portion of the pin (40) tapers to a smaller cross sectional area further towards a pin bottom (42).

## Patentansprüche

1. Kühlplatte (10), umfassend:
eine Einfassung (20) mit einem Untersatz (22), einem Deckel (24), einem Einlass (28) und einem Auslass (30);
eine Untersatzplatte (34), welche den Einfassungsuntersatz (22) bildet, wobei die Untersatzplatte (34) eine Insel (36) beinhaltet; und
eine Vielzahl von Stiften (40) innerhalb der Einfassung (20), die von der Untersatzplatte (34) in Richtung Einfassungsdeckel (24) verlaufen, wobei jeder Stift (40) eine Länge (46) und ein Querschnittsprofil (52) mit einer Richtung (54) aufweist, und wobei die Querschnittsprofilrichtung (54) sich entlang der Stiftlänge (46) ändert, **dadurch gekennzeichnet, dass** der Stift (40) mindestens für einen Abschnitt der Stiftlänge (46) ein spiralförmiges Erscheinungsbild aufweist.

2. Kühlplatte (10) nach Anspruch 1, wobei der Stift (40) eine Achse (48), eine Unterseite (42) und eine Oberseite (44) aufweist und die Stiftachse (48) sich zwischen der Unterseite (42) und der Oberseite (44) biegt.

3. Kühlplatte (10) nach Anspruch 1, wobei der Stift (40) eine Querschnittsfläche und eine Unterseite (42) aufweist, wo der Stift (40) mit der Untersatzplatte (34) verbunden ist, und sich die Querschnittsfläche zumindest über einen gewissen Abschnitt des Stifts (40) hinweg vergrößert, je weiter sie von der Stiftunterseite (42) weg ist, und wobei der Stift (40) monolithisch mit der Untersatzplatte (34) gebildet ist.

4. Kühlplatte (10) nach Anspruch 1, wobei der Stift (40) Seitenflächen (50) mit mindestens zwei verschiedenen Texturen (58) auf den Seitenflächen (50) aufweist, und wobei mindestens eine Textur (58) eine Vielzahl von Vertiefungen (60) aufweist.

5. Kühlplatte (10) nach Anspruch 4, wobei der Stift (40) mindestens drei verschiedene Texturen (58) auf der Seitenfläche (50) aufweist.

6. Kühlplatte (10) nach Anspruch 1, wobei der Stift (40) eine Breite (62) aufweist, die senkrecht zur Länge (46) verläuft, und das Seitenverhältnis des Stifts (40) zwanzig zu eins ist, wobei das Seitenverhältnis das Verhältnis der Stiftlänge (46) zur Stiftbreite (62) ist.

7. Kühlplatte (10) nach Anspruch 1, einschließlich einer Flusslinie (32) zwischen dem Einlass (28) und dem Auslass (30), und wobei die Stifte (40) im Wesentlichen parallel zu der Flusslinie (32) angeordnet sind.

8. Kühlplatte (10) nach Anspruch 1, wobei der Stift (40) monolithisch mit der Untersatzplatte (34) gebildet ist.

9. Verfahren zum Herstellen der Kühlplatte (10) nach Anspruch 1, umfassend:
Aufschneiden einer Untersatzplatte (34), um eine Vielzahl von Lamellen (70) zu bilden;
Kreuzschneiden der Untersatzplatte (34), nachdem die Lamellen (70) gebildet sind, um eine Vielzahl von Stiften (40) zu bilden;
Befestigen einer Abdeckung an der Untersatzplatte (34), sodass die Vielzahl von Stiften (40) sich innerhalb einer Einfassung (20) zwischen der Abdeckung und der Untersatzplatte (34) befindet; und
Bilden eines Einlasses (28) und eines Auslasses (30) zu der Einfassung (20).

10. Verfahren nach Anspruch 9, wobei die Untersatzplatte (34) so aufgeschnitten ist, dass eine Stiftachse (48) sich entlang einer Länge (46) des Stifts (40) biegt.

11. Verfahren nach Anspruch 9, wobei die Untersatzplatte (34) aufgeschnitten wird, ohne Material zu entfernen, sodass die Lamellen (70) sich von der Untersatzplatte (34) erheben.

12. Verfahren nach Anspruch 9, wobei die Untersatzplatte (34) aufgeschnitten wird, ohne Material zu entfernen, sodass die Stifte (40) sich von den Lamellen (70) erheben.

13. Verfahren nach Anspruch 9, wobei die Untersatzplatte (34) mit einem Werkzeug aufgeschnitten wird, um mindestens zwei Texturen (58) auf einer Seitenfläche (50) der Stifte (40) zu erzeugen.

14. Verfahren nach Anspruch 13, wobei mindestens eine Textur (58) auf der Seitenfläche (50) eine Vielzahl von Vertiefungen (60) umfasst.

15. Verfahren nach Anspruch 9, wobei die Untersatzplatte (34) so aufgeschnitten wird, dass ein unterer Abschnitt des Stifts (40) sich zu einer kleineren Querschnittsfläche näher an der Stiftunterseite (42) verjüngt.

## Revendications

1. Plaque froide (10) comprenant :
une enceinte (20) comportant une base (22), un couvercle (24), une entrée (28) et une sortie (30) ;
une plaque de base (34) formant la base d'enceinte (22), la plaque de base (34) comprenant une île (36) ; et
une pluralité de broches (40) au sein de l'enceinte (20) s'étendant à partir de la plaque de base (34) vers le couvercle d'enceinte (24), chaque broche (40) ayant une longueur (46) et un profil de coupe transversale (52) avec une orientation (54), et où l'orientation de profil en coupe transversale (54) change le long de la longueur de broche (46), **caractérisé en ce que** la broche (40) a une apparence spirale sur au moins une partie de la longueur de broche (46).

2. Plaque froide (10) selon la revendication 1, dont la broche (40) comporte un axe (48), un fond (42) et un sommet (44), et dont l'axe de broche (48) se courbe vers le fond (42) et vers le sommet (44).

3. Plaque froide (10) selon la revendication 1, dont la broche (40) a une surface en coupe transversale et un fond (42) où la broche (40) se raccorde à la plaque de base (34), et sur au moins une partie de la broche (40), la surface de coupe transversale augmente avec la distance du fond de broche (42), et où la broche (40) est monolithique avec la plaque de base (34).

4. Plaque froide (10) selon la revendication 1, dont la broche (40) a des surfaces latérales (50) dotées d'au moins deux textures différentes (58) sur les surfaces latérales (50) et dont au moins une texture (58) comprend un ensemble d'alvéoles (60).

5. Plaque froide (10) selon la revendication 4, dont la broche (40) compte au moins trois textures différentes (58) sur la surface latérale (50).

6. Plaque froide (10) selon la revendication 1, dont la broche (40) a une largeur (62) perpendiculaire à la longueur (46) et dont la broche (40) a un rapport de forme de vingt pour un, le rapport de forme étant le rapport entre la longueur de broche (46) et la largeur de broche (62).

7. Plaque froide (10) selon la revendication 1, comprenant une ligne d'écoulement (32) entre l'entrée (28) et la sortie (30), et où les broches (40) sont alignées sensiblement parallèlement à la ligne d'écoulement (32).

8. Plaque froide (10) selon la revendication 1, dont la broche (40) est monolithique avec la plaque de base (34).

9. Procédé de production de la plaque froide (10) selon la revendication 1, comprenant :
le découpage d'une plaque de base (34) pour former un ensemble d'ailettes (70) ;
le découpage transversal de la plaque de base (34) une fois que les ailettes (70) sont formées pour donner un ensemble de broches (40) ;
la fixation d'un couvercle à la plaque de base (34) de sorte que l'ensemble de broches (40) soit contenu dans une enceinte (20) entre le couvercle et la plaque de base (34) ; et
la formation d'une entrée (28) et d'une sortie (30) à l'enceinte (20).

10. Procédé selon la revendication 9, dans lequel la plaque de base (34) est découpée de sorte qu'un axe de broche (48) se plie le long d'une longueur (46) de la broche (40).

11. Procédé selon la revendication 9, dans lequel la plaque de base (34) est découpée sans retirer de matière, de sorte que les ailettes (70) s'élèvent à partir de la plaque de base (34).

12. Procédé selon la revendication 9, dans lequel la plaque de base (34) est découpée sans retirer de matière, de sorte que les broches (40) s'élèvent à partir des ailettes (70).

13. Procédé selon la revendication 9, dans lequel la plaque de base (34) est découpée avec un outil pour produire au moins deux textures (58) sur une surface latérale (50) des broches (40).

14. Procédé selon la revendication 13, dans lequel au moins une texture (58) de la surface latérale (50) comprend une pluralité d'alvéoles (60).

15. Procédé selon la revendication 9, dans lequel la plaque de base (34) est découpée de sorte qu'une partie inférieure de la broche (40) s'effile jusqu'à une plus petite surface de coupe transversale plus loin vers un fond de broche (42).
